# EUROPEAN PATENT SPECIFICATION

(11) **EP 1 684 408 B1**
(45) Date of publication and mention of the grant of the patent: **14.04.2010**
(21) Application number: 05001250.9
(22) Date of filing: 21.01.2005
(51) Int. Cl.: H02P 6/14, H02P 6/20, H02P 6/22, H02K 1/14

(54) **Electric motor system**
Elektromotor-System
Système à moteur électrique

(43) Date of publication of application: 26.07.2006
(73) Proprietor: Harman Becker Automotive Systems GmbH, 76307 Karlsbad (DE)
(72) Inventor: Ludwig, Michael, 74889 Sinsheim (DE); Lamparth, Oliver, 76359 Maxzell (DE); Kutzki, Arno, 75210 Keltern (DE); Rupprecht, Matthias, 75334 Straubenhardt (DE)
(74) Representative: Bertsch, Florian Oliver

(56) References cited:
- JP-A- 2004 072 909
- US-A- 5 492 458
- US-A1- 2004 124 831
- US-B1- 6 441 531
- PATENT ABSTRACTS OF JAPAN vol. 2003, no. 12, 5 December 2003 (2003-12-05) & JP 2004 072909 A (FUJITSU GENERAL LTD), 4 March 2004 (2004-03-04)

## Description

This invention relates to an electric motor system and to a method for controlling an electric motor system. In particular, the invention relates to electric motor ventilation systems which are used for cooling electronic components. While not limited to its application the invention is particularly adapted for use with brushless motor systems.

### Related Art

In the art, motor systems are known comprising a rotor including permanent magnets angularly displaced around the rotor, a stator comprising a winding having portions for intercepting the magnetic field of said permanent magnets during rotation of the motor and means for supplying to said winding an alternating voltage for energizing the winding and determining the speed of rotation of the rotor.

Furthermore, electronic multimedia systems are known which are often incorporated into a dashboard of a vehicle. These electronic systems comprise different electronic modules, e. g., a radio module, an audio module, a telecommunication module, and/or a navigation module. All these different modules are accommodated in a limited space behind the dashboard, so that these modules are arranged closely together. As a consequence, cooling systems have to be provided for cooling the different electronic modules.

EP 6 664 24 A1 discloses a ventilation system comprising an electronic motor comprising a first driving winding for driving the rotor and comprising a second winding working as a sensor winding. The second winding is used for detecting the relative position of the magnetic poles relative to pole pieces provided next to the winding. In this arrangement, two windings or coils are needed for the use of the motor. Additionally, four connecting pins are provided for the two different windings.

US 2004/0124831 A1 discloses a motor according to the preamble of claim 1.

### Summary of the invention

A need exists to provide a motor system with a simple design and which can be manufactured in a cost effective way.

This need is met by an electronic motor system and by a method for controlling an electronic motor system as mentioned in the independent claims. In the dependent claims, preferred embodiments of the invention are described.

According to a first aspect of the invention an electronic motor system is provided comprising a rotor comprising different permanent magnets, a stator comprising a winding through which current is flowing for driving the rotor. Additionally, a control unit is provided for controlling the current flowing through the winding. A first filter is provided for filtering the current flowing through the winding. For controlling the current the voltage supplied to the winding is controlled. A second filter is provided for filtering the current flowing through the winding and a comparator comparing the signal output of the first filter to the signal output of the second filter, wherein the control unit controls the current flowing through the winding depending on the result of the comparison of the two filtered signals. According to the invention one winding and the current flowing through this winding is used for controlling the current flowing through the winding. The provision of a second winding for detecting the relative position of the different elements of the motor relative to each other or the use of a hall element for detecting the position of the permanent magnets of the rotor is not necessary. The voltage supplied to the two terminals of the winding is extracted, and the signal of these two terminals is then further processed by using two different filters. The result of the comparison of the filtered signals is then used for controlling the current flowing through the winding. This allows to provide a compact electronic motor system with a simple design and which can be manufactured in a cost effective way. The inductive behaviour of the current flowing through the winding due to the changing magnetic flux provides information about the position of the rotor relative to the stator and can thus be used for controlling the motor system.

According to a preferred embodiment, the electric motor system is an electric motor ventilation system of a brushless motor. Ventilation means are preferably fixedly connected to the rotor. Preferably several paddles are connected to the rotor. When an alternating voltage for energizing the winding is supplied to the latter the rotor starts to rotate, and the ventilation system starts to cool the surrounding.

According to the invention, the control unit controls the direction of the current flowing through the winding in correspondence with the result of the comparison of the two filtered signals by controlling the direction of the current. By controlling the alternating voltage for energizing the winding the speed of rotation of the rotor can be controlled. According to a preferred embodiment of the invention the result of the comparison of the two filtered signals forms the basis for this control.

According to another embodiment of the invention the control unit comprises a converting unit which controls the direction of the current flowing through the winding. In correspondence with the result of the comparison of the two filtered signals the converting unit determines when the direction of the current through the winding has to be changed, so that the magnetic field outside the winding is changed and the permanent magnets of the rotor start or continue to rotate.

Preferably, the control unit changes the direction of the current flowing through the winding, when the output signal from the second filter exceeds the output signal from the first filter. The electric current flowing through the winding changes also due to the magnetic inductance resulting from the changing magnetic flux of the motor system. The current signal is filtered a first way in the first filter and filtered a second way in the second filter. When the output signal of the second filter exceeds the signal of the first filter the direction of the current has to be changed for driving the rotor.

According to a preferred embodiment of the invention the converting unit comprises a flip flop which changes the direction of the current based on the signal received from the comparator. Preferably, the flip flop is a T flip flop which inverts its output signals for inverting the direction of the current, when a trailing edge is detected on the output signal of the comparator. It is also possible to detect a rising edge when the two input signals of the comparator are exchanged. The comparator has two input signals receiving the two filtered signals from the first filter and the second filter. When one signal becomes larger than the other signal, the comparator changes its output from high to low. This trailing edge is then used as a clock signal in the T flip flop for changing the two output signals of the T flip flop.

Further, the converting unit can also comprise a lookup table in which the output signals are stored in accordance with an input signal. Still further, the converting unit can comprise any suitable means for converting an input signal received from the comparator into the respective output signal to drive the control unit.

Preferably, the first filter comprises a low pass filter having a first cut-off frequency f1. The second filter comprises also a low pass filter having a second cut-off frequency f2 which is higher than the first cut-off frequency f1. The current flowing through the winding which is changing due to the induction law is low pass filtered in a first way and low pass filtered in a second way. The second low pass filter having a higher cut-off frequency than the first low pass filter has the effect that the signal from the second low pass filter is less smoothened than the signal received from the first low pass filter. In the comparator these two filtered signals are compared. When the signal from the second filter is higher than the signal from the first filter the comparator changes its output and provides the clock signal for the converting unit, i. e., the flip flop for changing the direction of the current flow through the winding.

The filter used in the invention can be an analogue RC filter or LC filter or any suitable combination thereof. In a further integration process it might also be useful to use a DSP to implement digital filtering. The remaining parts, as e.g. the comparator, etc., might be included in a programmable digital device.

Preferably, the motor is a claw pole motor, the rotor comprising four circularly arranged permanent magnet poles wherein the permanent magnet poles have alternating poles in a circumferential direction. Preferably, the stator comprises a first and a second claw which are arranged on opposite sides of the stator. The two claws arranged on the opposite side of the stator or of the winding reinforce the magnetic field at the end of the winding and therefore help to reinforce the magnetic force between the permanent magnet poles of the rotor and the magnetic field generated by the winding.

Additionally, the motor system may further comprise a start unit for starting the motor, which comprises a clock unit providing clock pulses for changing the direction of the current through the winding until the motor has reached a predetermined rotational speed. This start unit can be used for starting the motor in a first phase of the operation of the motor. The clock pulses of the clock unit help to run the motor in an initial phase until a predetermined rotational speed has been reached. When a predetermined rotational speed (e. g. 50 to 100 rpm) is reached the control of the current flowing through the motor is performed as mentioned above using the two filtered signals, the comparator and the converter and the H-Bridge (or µC). The H-Bridge changes the direction of the current through the winding. The H-Bridge is controlled by the flip flop.

The invention further relates to a method for controlling an electronic motor system with a rotor and a stator with a winding through which current is flowing for driving the rotor, the method comprising the following steps: The current flowing through the winding is extracted and filtered by a first filter. Additionally, the current is filtered using a second filter. In a next step, the two filtered signals are compared and the direction of the current flowing through the winding is changed in correspondence with the result of the comparison. As mentioned above, the current flowing through the winding is influenced by the magnetic induction due to the changing magnetic flux. The current signal extracted from the winding is fed to two different filters and the output signals of the filters are then compared. This resulting current signal provides information on the position of the rotor and can, therefore, be used to control the direction of the current through the winding.

According to another embodiment of the invention, the two filtered signals are fed to a comparator which compares the two filtered signals and which transmits a result of the comparison to a converting unit which inverts the direction of the current flowing through the winding based on the result of the comparison.

### Brief Description of the Drawings

The invention will be fully understood from consideration of the following detailed description thereof with reference to the accompanying drawings in which:
- Fig. 1: shows an exploded view of a claw pole motor which can be used in the motor control system of the invention,
- Fig. 2: shows a top view of a claw pole motor,
- Fig. 3: shows different positions of a claw pole motor and the current direction explaining the functioning of the motor,
- Fig. 4: shows a schematic view of a motor control system which can be used for controlling the motor, and
- Fig. 5: shows a circuit diagram of the motor control system and a signal course of the different components of the system.
- Fig. 6: shows a fan unit comprising an electric motor system according to the invention.

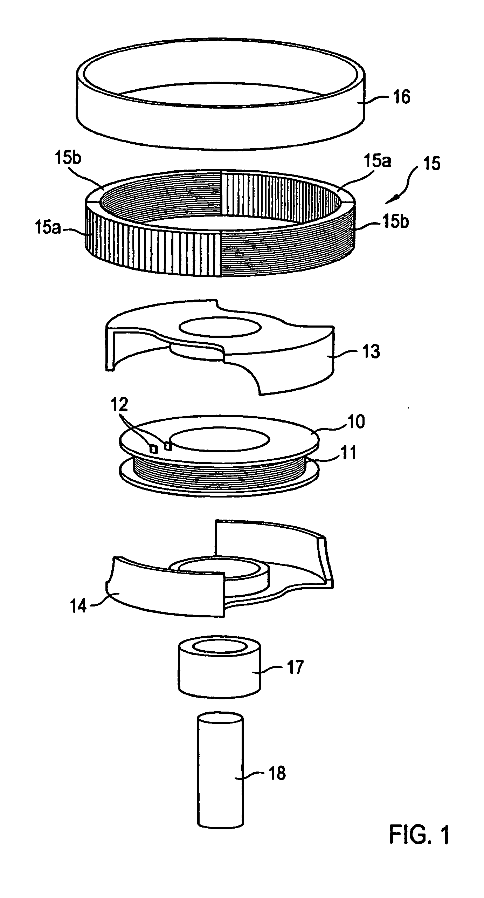

In Fig. 1 an exploded view of a claw pole motor can be seen. The motor comprises a stator 10 comprising one winding 11 which is wound around the stator 10. Additionally, two terminals 12 are provided on the stator for supplying to said winding an alternating voltage and therefore an alternating current. The motor further comprises an upper claw 13 and a lower claw 14. When a current is flowing through the winding 11 a magnetic field will be generated, having a first pole on the side of the claw 13 and having another pole on the side of the other claw 14. The claws 13 and 14 which are made of a magnetic material concentrate and reinforce the magnetic field in the upper and in the lower part of the stator 10. Additionally, a rotor 15 is provided which is composed of four different permanent magnets 15a and 15b, respectively. It should be understood that any other number of permanent magnets could be used. The number of poles will be chosen depending on the area of application of the motor. On the outer side of the rotor a metallic ring 16 may be provided to which the ventilation system in form of paddles (not shown) or the like may be connected. Additionally, a sliding bearing 17 and a shaft 18 are provided. The functioning of a claw pole motor is well-known in the art, so that a detailed description of the different components is omitted. According to one aspect of the invention, only one winding is needed in this motor, a second winding for determining the position of the rotor and the permanent magnets relative to the winding and its claws is not necessary. As a matter of course, the invention is not limited to electric claw pole motors, but can be used in connection with every electric motor.

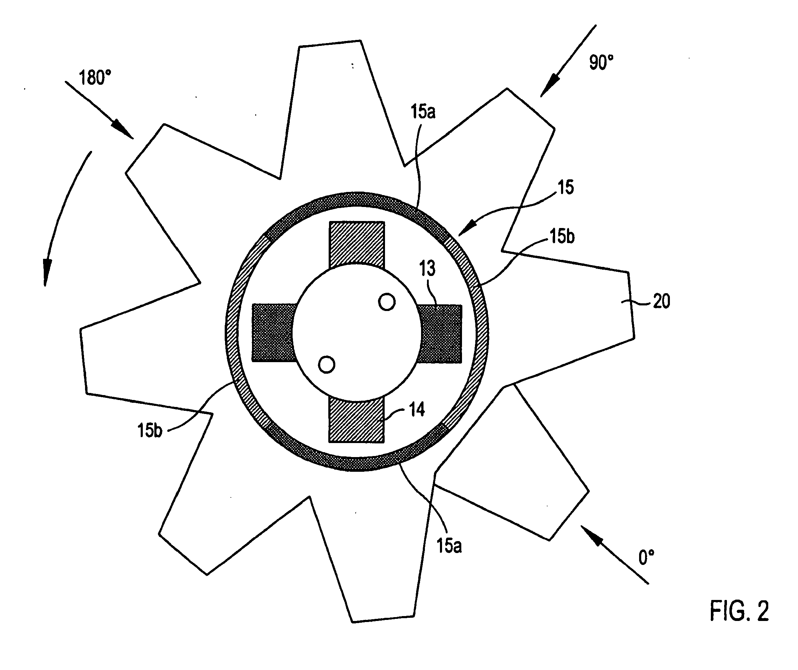

In Fig. 2 a top view of an electric motor ventilation system is shown. On the outer part of the rotor paddles 20 of the fan are provided. Additionally, the rotor 15 with the magnets of different polarity 15a and 15b is shown. In the embodiment shown the current flowing through the winding is flowing in such a direction that the upper claw 13 has the same polarity as the magnets 15a and has a different polarity compared to the magnets 15b. As a consequence, the lower claw 14 has the same polarity as have the magnets 15b.

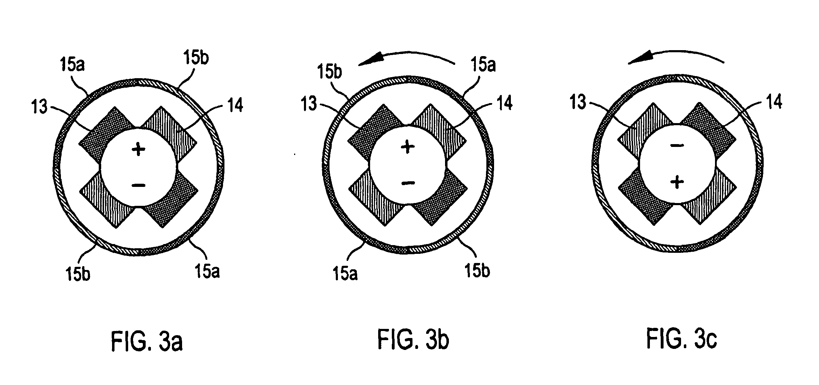

In the following, the functioning of a claw pole motor will be described in connection with Figs. 2 and 3. In Fig. 3a the direction of the current is such that the polarity of the claw 13 is the same as the polarity of the permanent magnet 15a facing the claw 13. Due to the repulsive force of the magnets the rotor 15 will start to turn in the direction as indicated by the arrow in Fig. 3b. The rotation will stop when the rotor has performed a 90 degree turn as can be seen in Fig. 2. When the direction of the current is changed in the winding as indicated by the changed signs + and - the polarity of the claws 13 and 14 changes, cf. Fig. 3c. The rotor will then again turn by 90 degrees in the direction as indicated by the arrow. As can be seen by Figs. 2 and 3 each changing of the direction of the current flowing through the winding will induce a 90 degree rotation of the rotor.

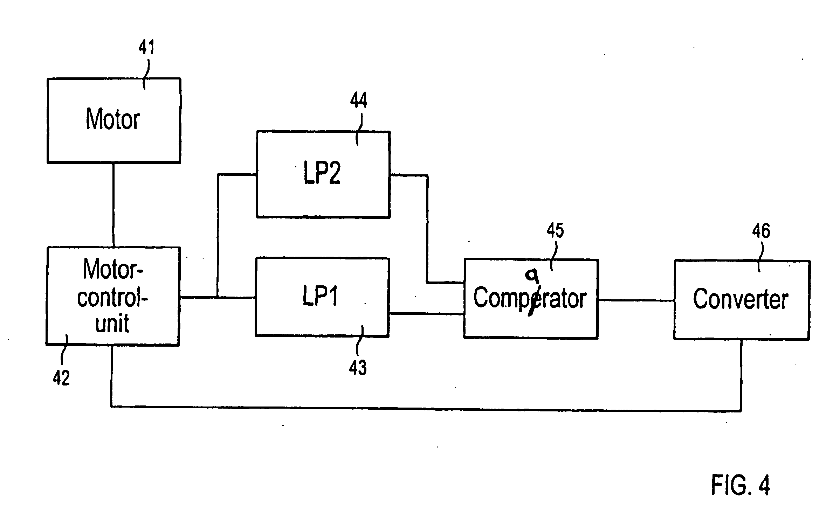

In Fig. 4 a schematic view of an electronic motor system of the invention is shown. The system comprises an electric motor 41, which can be a brushless motor such as a claw pole motor as described in connection with Figs. 1 to 3. The motor of the invention comprises one winding 11 which is used for driving the rotor and which is also used for determining the position of the rotor relative to the stator. It should be understood that the motor 41 could also comprise additional windings, however, these windings are not necessary for controlling the motor. For controlling the motor and especially for controlling the direction of the current flowing through the winding a motor control unit (= e.g. H-Bridge) 42 is provided. The control unit can comprise a start unit for starting the motor which provides a clock signal for changing the direction of the currents through the winding and, therefore, for changing the commutating frequency of the rotor. This start unit can be used until the rotor has reached a predetermined rotational speed. This rotational speed depends on the condition of use of the motor itself. In one embodiment, the rotational speed may be around 90 Hz. When this rotational commutating frequency is reached the controlling of the motor is obtained as discussed in detail below. The motor control unit can further stop the motor by turning the current off. In order to vary or change the motor speed the duty cycle can be changed.

An alternating voltage is supplied to the two connecting terminals (not shown) of the winding and, therefore, an alternating current is flowing through the winding. For the controlling of the motor the point of time at which the direction of current has to be changed has to be determined. To this end, the voltage signal at the two terminals is extracted, and voltage is fed to a first low pass filter 43 having a first cut-off frequency f1. Additionally, the same current signal is fed to a second low pass filter 44 having a second cut-off frequency f2 which is higher than the first cut-off frequency.

According to the invention, the change of the current due to the change of the magnetic flux induced by Faraday's Law is used for determining the point of time at which the direction of current has to be changed in the winding. The first cut-off frequency f1 and the second cut-off frequency f2 may be selected in such a way that the second cut-off frequency f2 is around ten to twenty times larger than the first cut-off frequency f1. By way of example, the cut-off frequency f1 of the first low pass filter may be between 10 and 20 Hz, the cut-off frequency f2 of the second low pass filter may be between 150 and 250 Hz. The characteristics of the low pass filters are selected in such a way that the existing possible frequency components in the output signal of the first low pass filter 43 are much more attenuated than the signals filtered by the second low pass filter 44. The two filtered signals received from the filters 43 and 44 are compared in a comparator 45 and a signal corresponding to the result is generated. The result of the comparison is then fed to a converter 46 which generates the converting signal so that the motor control unit 42 will change the direction of the current flowing through the winding accordingly.

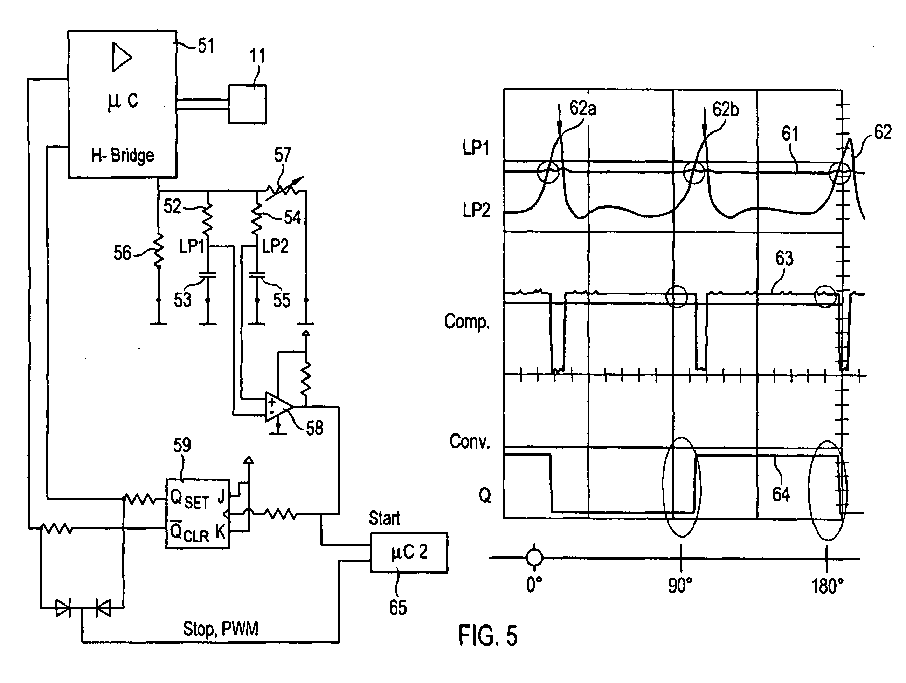

In Fig. 5 the components of the motor system of Fig. 4 are shown in more detail. Additionally, the time courses of the signals of the different components are shown in Fig. 5. The motor control unit shown in Fig. 4 comprises a micro controller 51 which inter alia generates the alternating voltage and therefore the current flowing through the winding 11. By way of example, the micro controller may comprise a H-bridge. The second µC 65 is for start, stop and speed control. If the motor control unit is a µC in place of te H-Bridge it can also handle start, stop and speed control.

The current signal of the current flowing through the winding is extracted from the H-Bridge and resistant 56 and is further processed as shown in Fig. 5. The current signal is fed to a first low pass filter composed by the resistance 52 and the capacitor 53. The current signal is furthermore fed to the second low pass filter composed of the resistance 54 and the capacitor 55. The resistances and the capacitors are chosen in such a way that the cut-off frequency of the second low pass filter is around ten to twenty times higher than the cut-off frequency of the first low pass filter. By way of example, the resistances 52 and 54 can be chosen as 82KΩ resistors, the capacitor 53 could be a 150 nF capacitor, the capacitor 55 could be a 10 nF capacitor. It should be understood that the components of the two low pass filters will be chosen in such a way that the cut-off frequencies are in accordance with the rotational speed of the motor, the latter depending on the intended use of the motor. It should be understood that other values for the resistances and the capacitors could be used.

Additionally, a resistance 56 may be provided to stabilize the output signal of the micro controller 51 at a predetermined level. Additionally, a potentiometer 57 or fixed resistor may be provided for adjusting an operating point of the system.

The output signals of a low pass filter composed by the components 52 and 53 and the output signal of the low pass filter composed by the components 54 and 55 are respectively used as input signals for the comparator 58. In the right part of Fig. 5 an example of signals of the motor system is shown. The signal course 61 shows the output signal of the low pass filter 43 at point LP1, 62 showing the time course of the signal at point LP2. As can be seen from graphs 61 and 62, the frequency components are attenuated in a different way. As the graph 61 shows, the first low pass filter 43 attenuates the existing frequency components much more than the second low pass filter 44 as shown by graph 62. As can further be seen from graph 61 the latter is nearly a straight line as a result of the low cut-off frequency. In the following, the course of the graph 62 will be explained in detail.

When the direction of the current through the winding is changed in such a way, that the rotor starts to rotate due to the magnetic forces of the permanent magnets of the rotor and the magnetic forces induced in the claws of the stator, the rotor rotates by 90 degrees. When the rotor starts to rotate the magnetic flux of the motor system starts to change due to magnetic inductance, as the magnetic field is changing. Due to this, the current flowing through the winding will decrease, as the magnetic inductance counteracts the normal direction of flow. This means, that starting from location 62a of Fig. 5, the apex 62a, the current will decrease as shown between the two locations 62a and 62b. When the rotor has finished a 90 degree turn, i. e., when the rotor has turned in such a way that the permanent magnets and the claws they face have a different polarity, the rotation will stop and the induction current will become zero, so that the current through the winding will reach location 62b. When the turning of the motor stops the voltage signal 62 starts to raise again and therefore the current flowing through the winding. When the magnetic poles of different polarity face each other, the polarity of the winding has to be changed again. In the context of Fig. 5 this means that whenever course 62 starts to rise again the system knows, that the direction of current has to be changed again. The system is configured in such a way that whenever the rising ramp of graph 62 intersects graph 61 it decides that it is time to change the polarity of the winding. As indicated by the arrows in the right part of Fig. 5 the intersection of the two graphs 61 and 62 is used as a clock signal. The clock signal is generated by the comparator 58 which compares the two signals 61 and 62. The output signal of the comparator 58 is fed to the clock input of a T flip flop 59 which acts as the converter 46 of Fig. 4. Every time, when a trailing edge is detected in the output signal of the comparator, the output signals of the flip flop change from high to low and from low to high and vice versa. Every time the output signal of the flip flop is changed the direction of the current flowing through the winding 11 is changed as can be seen by graph 64 shown in Fig. 5. At each trailing edge of the output signal of the comparator 58 shown by graph 63 the flip flop changes its state (graph 64). The two output signals of the flip flop are connected to the micro controller 51, in which the polarity of the alternating voltage is changed and, therefore, the direction of the current.

As can be seen from Figs. 4 and 5 the use of a single winding is enough to drive the motor of the electric motor system of the invention by analysing the inductive behaviour of this winding 11 and by a further processing of the signal as shown in Fig. 5. The position of the rotor can thus be determined and therefore the moment of time is known at which the direction of the current through the winding has to be changed to ensure a continuing rotation of the rotor.

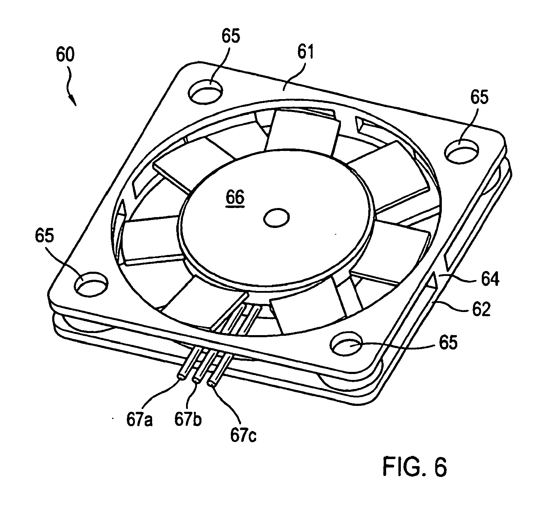

In Fig. 6, a fan unit comprising an electric motor system according to the invention is shown. The fan unit 60 comprises a front plate 61 and a back plate 62 for supporting an electric motor 66 as shown, for example, in Fig. 2, in a sandwich structure. The front plate 61 and the back plate 62 are connected via lateral webs 64 and by screws inserted into through holes 65 to form a housing for the electric motor 66. The electric motor 66 comprises three connection pins 67A, 67B and 67C by which the device can be directly attached to a printed circuit board. In the embodiment shown in Fig. 6 the three connection pins 67A, 67B, 67C may serve for voltage supply, ground, and diagnose, respectively. While in Fig. 6 there are shown three connection pins 67A, 67B, 67C the invention is not limited to this structure and may comprise more or less connection pins.

Further, while in Fig. 6 the connection pins are shown to extend from the center of the upper plate 61, it is possible to modify the structure of the fan unit 60 with regard to the position of the connection pins in order to provide a modified embodiment optimized for the respective desired application. Preferably, the connection pins are formed as male connectors of a plug-in connector with female connectors formed at the circuit board.

An important feature of the embodiment shown in Fig. 6 is that the fan unit can be directly attached to the printed circuit board via connection pins 64A, 64B, 64C by attaching the fan unit to a printed circuit board (not shown in the embodiment) and soldering the pins to the printed circuit board, for example. This structure provides the particular advantage that it is not necessary to provide a further connector for electrical connection of the fan unit to the circuit board. Thereby, the number of required components can be significantly reduced. Furthermore, the assembling time during assembling of a navigation system, for example, can be significantly shortened. There is no risk of failure due to a non-connected connector. The number of connection points is reduced as well.

Of course, the general concept of directly attaching a fan unit to the printed circuit board via respective connection pins may be utilized independently of the controlling method described above, that is, any fan motor known from the art may be used to be directly attached to the circuit board by use of respective connections pins as shown in the structure of Fig. 6, for example.

In conclusion, the present invention provides a simple electronic motor system, in which the behaviour of the current flowing through the winding can also be used for controlling the direction of the current flowing through the winding. A basic analyses of the signal with the use of two low pass filters, one comparator and one converting unit provides a straight forward control of the motor. It should be understood that other components than those shown in Fig. 5 could be used without deviating from the scope of the invention. The comparison of the two differently filtered signals helps to get sufficient information about the position of the rotor relative to the stator.

## Claims

1. Electric motor system comprising:
- a rotor (15) comprising different permanent magnets ,
- a stator (10) comprising a winding (11) through which current is flowing for driving the rotor,
- a control unit (42) for controlling and detecting the current flowing through the winding,
- a first filter (43) for filtering the current flowing through the winding,
- a second filter (44) for filtering the current flowing through the winding,
- a comparator (45) for comparing the output signal from the first filter to the output signal from the second filter,
**characterized in that** the control unit controls the current flowing through the winding depending on the result of the comparison of the two filtered signals, wherein the control unit (42) controls the direction of the current flowing through the winding in correspondence with the result of the comparison of the two filtered signals.

2. Motor system according to claim 1, wherein the electric motor system is an electric motor ventilation system, wherein ventilation means are fixedly connected to the rotor (15).

3. Motor system according to any of the preceding claims, wherein the control unit (42) comprises a converting (46) unit which controls the direction of the current flowing through the winding (11) in correspondence with the result of the comparison of the two filtered signals.

4. Motor system according to any of the preceding claims, wherein the control unit (42) changes the direction of the current flowing through the winding when the signal from the second filter (44) exceeds the signal form the first filter (43).

5. Motor system according to claim 3 or 4, wherein the converting unit comprises a flip flop (59) which changes the direction of the current based on the signal received from the comparator.

6. Motor system according to any of claims 3 to 5, wherein the converting unit comprises a T flip flop (59) which inverts its output signals for inverting the direction of the current, when a trailing edge is detected on the output signal of the comparator (58).

7. Motor system according to any of the preceding claims, wherein the first filter (43) comprises a low pass filter having a first cut-off frequency.

8. Motor system according to claim 7, wherein the second filter (44) comprises a low pass filter having a second cut off frequency which is higher than the first cut-off frequency.

9. Motor system according to any of the preceding claims, wherein the motor is a claw pole motor, the rotor comprising four circularly arranged permanent magnet poles (15a, 15b), wherein the permanent magnet poles have alternating poles in a circumferential direction, the stator (10) comprising a first and second claw (13, 14) which are arranged on opposite sides of the stator.

10. Motor system according to any of the preceding claims, **characterized by** further comprising a start unit for starting the motor which comprises a clock unit providing clock pulses for changing the direction of the current through the winding until the motor has reached a predetermined rotational speed.

11. Fan unit comprising a motor system according to any of the preceding claims, **characterized in that** the electric motor (66) comprises pins (67A, 67B, 67C) for direct attachment to a printed circuit board.

12. Method for controlling an electric motor system with a rotor (15) and a stator (10) with a winding (11) to which a voltage is supplied for driving the rotor, the method comprising the following steps:
- filtering the voltage with a first filter (43),
- filtering the voltage with a second filter (44),
- comparing the two filtered signals,
- changing the direction of current flowing through the winding in correspondence with the result of the comparison, wherein the two filtered signals are fed to a comparator which compares the two filtered signals and which transmits a result of the comparison to a converting unit which initiates the inversion of the direction of current flowing through the winding based on the result of the comparison.

## Patentansprüche

1. Elektromotorsystem umfassend:
- einen Rotor (15), welcher verschiedene Permanentmagnete umfasst,
- einen Stator (10), welcher eine Wicklung (11) umfasst, durch welche ein Strom zum Antreiben des Rotors fließt,
- eine Steuereinheit (42) zum Steuern und Erfassen des Stroms, welcher durch die Wicklung fließt,
- ein erstes Filter (43) zum Filtern des Stroms, welcher durch die Wicklung fließt,
- ein zweites Filter (44) zum Filtern des Stroms, welcher durch die Wicklung fließt,
- einen Komparator (45) zum Vergleichen des Ausgangssignals vom dem ersten Filter mit dem Ausgangssignal von dem zweiten Filter,
**dadurch gekennzeichnet, dass** die Steuereinheit den Strom, welcher durch die Wicklung fließt, in Abhängigkeit von dem Ergebnis des Vergleichs der zwei gefilterten Signale steuert, wobei die Steuereinheit (42) die Richtung des Stroms, welcher durch die Wicklung fließt, in Übereinstimmung mit dem Ergebnis des Vergleichs der zwei gefilterten Signale steuert.

2. Motorsystem nach Anspruch 1, wobei das Elektromotorsystem ein Elektromotorventilationssystem ist, wobei Ventilationsmittel fest mit dem Rotor (15) verbunden sind.

3. Motorsystem nach einem der vorhergehenden Ansprüche, wobei die Steuereinheit (42) eine Umsetzeinheit (46) umfasst, welche die Richtung des Stroms, welcher durch die Wicklung (11) fließt, in Übereinstimmung mit dem Ergebnis des Vergleichs der zwei gefilterten Signale steuert.

4. Motorsystem nach einem der vorhergehenden Ansprüche, wobei die Steuereinheit (42) die Richtung des Stroms, welcher durch die Wicklung fließt, ändert, wenn das Signal von dem zweiten Filter (44) das Signal von dem ersten Filter (43) überschreitet.

5. Motorsystem nach Anspruch 3 oder 4, wobei die Umsetzeinheit ein Flip-Flop (59) umfasst, welches die Richtung des Stroms auf der Grundlage des von dem Komparator empfangenen Signals ändert.

6. Motorsystem nach einem der Ansprüche 3-5, wobei die Umsetzeinheit ein T-Flip-Flop (59) umfasst, welches seine Ausgangssignale zum Invertieren der Richtung des Stroms invertiert, wenn eine fallende Flanke an dem Ausgangssignal des Komparators (58) erfasst wird.

7. Motorsystem nach einem der vorhergehenden Ansprüche, wobei das erste Filter (43) ein Tiefpassfilter mit einer ersten Grenzfrequenz umfasst.

8. Motorsystem nach Anspruch 7, wobei das zweite Filter (44) ein Tiefpassfilter mit einer zweiten Grenzsequenz, welche höher als die erste Grenzfrequenz ist, umfasst.

9. Motorsystem nach einem der vorhergehenden Ansprüche, wobei der Motor ein Klauenpolmotor ist, wobei der Rotor vier kreisförmig angeordnete Permanentmagnetpole (15a, 15b) umfasst, wobei die Permanentmagnetpole in einer Umfangsrichtung wechselnde Pole aufweisen, wobei der Stator (10) eine erste und zweite Klaue (13, 14) umfasst, welche an gegenüberliegenden Seiten des Stators angeordnet sind.

10. Motorsystem nach einem der vorhergehenden Ansprüche, **dadurch gekennzeichnet, dass** es ferner eine Starteinheit zum Starten des Motors umfasst, welche eine Takteinheit umfasst, welche Taktpulse zum Ändern der Richtung des Stroms durch die Wicklung bereitstellt, bis der Motor eine vorbestimmte Drehgeschwindigkeit erreicht hat.

11. Lüftereinheit umfassend ein Motorsystem nach einem der vorhergehenden Ansprüche, **dadurch gekennzeichnet, dass** der Elektromotor (66) Anschlussstifte (67A, 67B, 67C) zum direkten Anbringen an einer Platine umfasst.

12. Verfahren zum Steuern eines Elektromotorsystems mit einem Rotor (15) und einem Stator (10) mit einer Wicklung (11), an welche eine Spannung zum Antreiben des Rotors angelegt wird, wobei das Verfahren die folgenden Schritte umfasst:
- Filtern der Spannung mit einem ersten Filter (43),
- Filtern der Spannung mit einem zweiten Filter (44),
- Vergleichen der zwei gefilterten Signale,
- Ändern der Richtung eines Stroms, welcher durch die Wicklung fließt, in Übereinstimmung mit dem Ergebnis des Vergleichs, wobei die zwei gefilterten Signale zu einem Komparator geführt werden, welcher die zwei gefilterten Signale vergleicht und welcher ein Ergebnis des Vergleichs zu einer Umsetzeinheit überträgt, welche die Invertierung der Richtung des Stroms, welcher durch die Wicklung fließt, auf der Grundlage des Ergebnisses des Vergleichs einleitet.

## Revendications

1. Système de moteur électrique comprenant:
- un rotor (15) comprenant des aimants permanents différents,
- un stator (10) comprenant un enroulement (11) dans lequel circule un courant pour entraîner le rotor,
- une unité de commande (42) pour commander et détecter le courant circulant dans l'enroulement,
- un premier filtre (43) pour filtrer le courant circulant dans l'enroulement,
- un deuxième filtre (44) pour filtrer le courant circulant dans l'enroulement,
- un comparateur (45) pour comparer le signal de sortie du premier filtre au signal de sortie du deuxième filtre,
**caractérisé en ce que** l'unité de commande commande le courant circulant dans l'enroulement en fonction du résultat de la comparaison des deux signaux filtrés, l'unité de commande (42) commandant la direction du courant circulant dans l'enroulement conformément au résultat de la comparaison des deux signaux filtrés.

2. Système de moteur selon la revendication 1, dans lequel le système de moteur électrique est un système de ventilation de moteur électrique, dans lequel des moyens de ventilation sont solidarisés au rotor (15).

3. Système de moteur selon l'une quelconque des revendications précédentes, dans lequel l'unité de commande (42) comprend une unité de conversion (46) commandant la direction du courant circulant dans l'enroulement (11) conformément au résultat de la comparaison des deux signaux filtrés.

4. Système de moteur selon l'une quelconque des revendications précédentes, dans lequel l'unité de commande (42) change la direction du courant circulant dans l'enroulement lorsque le signal du deuxième filtre (44) est supérieur au signal du premier filtre (43).

5. Système de moteur selon la revendication 3 ou 4, dans lequel l'unité de conversion comprend un bistable (59) qui change la direction du courant en fonction du signal reçu du comparateur.

6. Système de moteur selon l'une quelconque des revendications 3 à 5, dans lequel l'unité de conversion comprend un bistable T (59) qui invertit ses signaux de sortie pour invertir la direction du courant lorsqu'un flanc arrière est détecté sur le signal de sortie du comparateur (58).

7. Système de moteur selon l'une quelconque des revendications précédentes, dans lequel le premier filtre (43) comprend un filtre passe-bas présentant une première fréquence de coupure.

8. Système de moteur selon la revendication 7, dans lequel le deuxième filtre (44) comprend un filtre passe-bas présentant une deuxième fréquence de coupure qui est plus élevée que la première fréquence de coupure.

9. Système de moteur selon l'une quelconque des revendications précédentes, dans lequel le moteur est un moteur à pôles à griffes, le rotor comprenant quatre pôles d'aimant permanent (15a, 15b) arrangés de manière circulaire, les pôles d'aimant permanent présentant des pôles alternants dans une direction circonférentielle, le stator (10) comprenant une première et une deuxième griffes (13, 14) arrangées respectivement sur des côtés opposées du stator.

10. Système de moteur selon l'une quelconque des revendications précédentes, **caractérisé en ce qu'**il comprend en outre une unité de démarrage pour démarrer le moteur comprenant une unité d'horloge fournissant des impulsions d'horloge pour changer la direction du courant à travers l'enroulement jusqu'á ce que le moteur ait atteint une vitesse de rotation prédéterminée.

11. Unité de ventilation comprenant un système à moteur selon l'une quelconque des revendications précédentes, **caractérisée en ce que** le moteur électrique (66) comprend des broches (67A, 67B, 67C) pour une fixation directe sur une plaquette de circuit imprimé.

12. Procédé de commande d'un système de moteur électrique comprenant un rotor (15) et un stator (10) comprenant un enroulement (11) auquel est appliquée une tension pour entraîner le rotor, le procédé comprenant les étapes suivantes:
- filtrage de la tension avec un premier filtre (43),
- filtrage de la tension avec un deuxième filtre (44),
- comparaison des deux signaux filtrés,
- changement de la direction du courant circulant dans l'enroulement conformément au résultat de la comparaison, les deux signaux filtrés alimentant un comparateur qui compare les deux signaux filtrés et qui transmet un résultat de la comparaison à une unité de conversion qui initie l'inversion de la direction de circulation du courant circulant dans l'enroulement en fonction du résultat de la comparaison.
